# EUROPEAN PATENT APPLICATION

(11) **EP 4 675 919 A1**
(43) Date of publication of application: **07.01.2026**
(21) Application number: 25187485.5
(22) Date of filing: 04.07.2025
(51) Int. Cl.: H03F 1/30, H03F 3/50

(54) **PUSH-PULL SOURCE FOLLOWER CIRCUIT USING BIASING TECHNIQUE TO PROGRAM BIAS CURRENT AND OUTPUT MEAN VOLTAGE INDEPENDENTLY**

(30) Priority: 05.07.2024 US 202463667843 P; 02.07.2025 US 202519257504
(71) Applicant: MEDIATEK INC., Hsinchu City 30078 (TW)
(72) Inventor: PARK, Henry Arnold, San Jose, 95134 (US); Atharav, San Jose, 95134 (US); GANDARA, Miguel Francisco, San Jose, 95134 (US); ALI, Tamer Mohammed, San Jose, 95134 (US)
(74) Representative: Haseltine Lake Kempner LLP

(57) **Abstract**

A push-pull source follower circuit (100) includes a main source follower (102), a first biasing circuit (104), and a second biasing circuit (106). The main source follower (102) includes a first transistor and a second transistor between a first power rail and a second power rail, where the first transistor and the second transistor include an N-type transistor and a P-type transistor. The first biasing circuit (104) programs a bias current of the main source follower (102) through generating a first bias voltage of the first transistor. The second biasing circuit (106) programs an output mean voltage of the push-pull source follower circuit (100) through generating a second bias voltage of the second transistor. The bias current and the output mean voltage are programmed independently.

## Description

### Field of the Invention

The present invention relates to an integrated circuit, and more particularly, to a push-pull source follower circuit using the proposed biasing technique to program a bias current and an output mean voltage independently.

### Background of the Invention

A push-pull source follower (also called complementary source follower) is formed by a P-type source follower and an N-type source follower, where the P-type source follower is implemented using a P-type metal-oxide-semiconductor (PMOS) transistor, and the N-type source follower is implemented using an N-type metal-oxide-semiconductor (NMOS) transistor. Compared to a single source follower that does not adopt a complementary structure, the push-pull source follower has several advantages, including a larger gain, much lower output impedance, higher power efficiency, etc. However, the push-pull biasing is one major obstacle encountered in the push-pull source follower design.

### Summary of the Invention

The scope of the present invention is defined by the claims.

This in mind, the present invention aims at providing a push-pull source follower circuit using the proposed biasing technique to program a bias current and an output mean voltage independently.

This is achieved by a push-pull source follower circuit according to the independent claim. The dependent claims pertain to corresponding developments and improvements.

As will be seen more clearly from the detailed description following below, the claimed push-pull source follower circuit includes a main source follower, a first biasing circuit, and a second biasing circuit. The main source follower includes a first transistor and a second transistor. The first transistor has a control terminal, a first connection terminal, and a second connection terminal, wherein the second connection terminal of the first transistor is coupled to a first power rail, and the first terminal of the first transistor is coupled to an output node of the push-pull source follower circuit. The second transistor has a control terminal, a first connection terminal, and a second connection terminal, wherein the second connection terminal of the second transistor is coupled to a second power rail, the first terminal of the second transistor is coupled to the output node of the push-pull source follower circuit, and the first transistor and the second transistor comprise an N-type transistor and a P-type transistor. The first biasing circuit is configured to program a bias current of the main source follower through generating and outputting a first bias voltage to the control terminal of the first transistor. The second biasing circuit is configured to program an output mean voltage of the push-pull source follower circuit through generating and outputting a second bias voltage to the control terminal of the second transistor. The bias current and the output mean voltage are programmed independently.

### Brief Description of the Drawings

In the following, the invention is further illustrated by way of example, taking reference to the accompanying drawings. Thereof
FIG. 1 is a diagram illustrating a first push-pull source follower design using the proposed biasing technique according to an embodiment of the present invention,
FIG. 2 is a diagram illustrating a second push-pull source follower design using the proposed biasing technique according to an embodiment of the present invention,
FIG. 3 is a diagram illustrating a third push-pull source follower design using the proposed biasing technique according to an embodiment of the present invention,
FIG. 4 is a diagram illustrating a fourth push-pull source follower design using the proposed biasing technique according to an embodiment of the present invention,
FIG. 5 is a diagram illustrating a fifth push-pull source follower design using the proposed biasing technique according to an embodiment of the present invention, and
FIG. 6 is a diagram illustrating a sixth push-pull source follower design using the proposed biasing technique according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

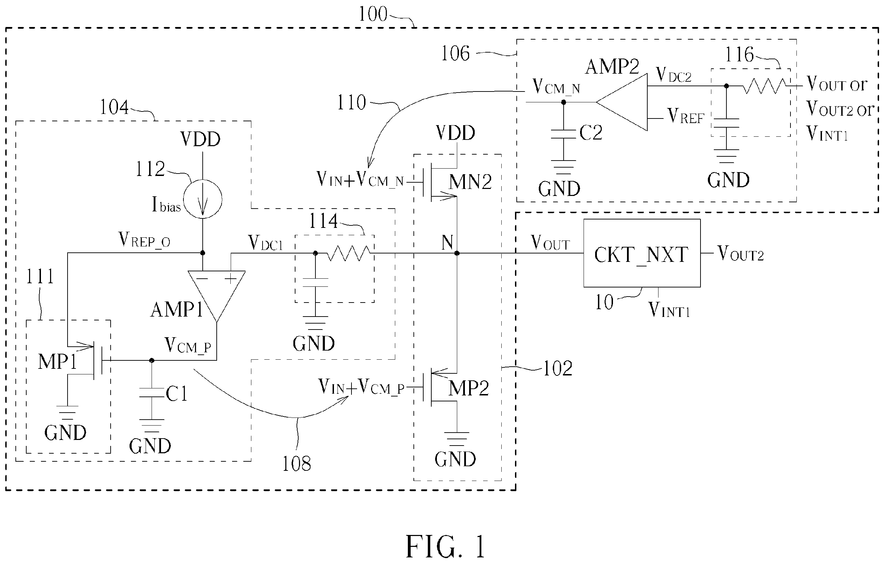

FIG. 1 is a diagram illustrating a first push-pull source follower design using the proposed biasing technique according to an embodiment of the present invention. The push-pull source follower circuit 100 is based on a complementary structure, and adopts the proposed biasing technique to independently program a bias current and an output mean voltage. In this embodiment, the push-pull source follower circuit 100 includes a main source follower 102 and a plurality of biasing circuits 104 and 106. The main source follower 102 includes transistors MN2 and MP2, where the transistor MN2 is an NMOS transistor acting as an N-type source follower, and the transistor MP2 is a PMOS transistor acting as a P-type source follower. The transistor MN2 has a gate terminal (which acts as a control terminal), a source terminal (which acts as a first connection terminal), and a drain terminal (which acts as a second connection terminal), where the source terminal is coupled to an output node N of the push-pull source follower circuit 100, and the drain terminal is coupled to a power rail on which a supply voltage VDD is delivered. The transistor MP2 has a gate terminal (which acts as a control terminal), a source terminal (which acts as a first connection terminal, and a drain terminal (which acts as a second connection terminal), where the source terminal is coupled to the output node N of the push-pull source follower circuit 100, and the drain terminal is coupled to a power rail on which a ground voltage GND is delivered.

The biasing circuit 104 is configured to program a bias current of the main source follower 102 through generating and outputting a bias voltage V_{CM_P} to the gate terminal of the transistor MP2. The bias voltage V_{CM_P} may be supplied to the gate terminal of the transistor MP2 through a coupling circuit 108 such as an active coupler or a passive coupler. For example, the coupling circuit 108 may be implemented using a direct-current (DC) level shifter including an alternating-current (AC) coupling capacitor and a DC bias resistor, where the AC coupling capacitor passes an AC component of an input voltage V_{IN}, and the DC bias resistor adds a DC bias (i.e., bias voltage V_{CM_P}) to the AC component V_{IN}, thus resulting in a gate voltage (V_{IN}+V_{CM_P}) at the gate terminal of the transistor MP2.

The biasing circuit 106 is configured to program an output mean voltage (i.e., a DC level of an output voltage V_{OUT}) of the push-pull source follower circuit 100 through generating and outputting a bias voltage V_{CM_N} to the gate terminal of the transistor MN2. The bias voltage V_{CM_N} may be supplied to the gate terminal of the transistor MN2 through a coupling circuit 110 such as an active coupler or a passive coupler. For example, the coupling circuit 110 may be implemented using a DC level shifter including an AC coupling capacitor and a DC bias resistor, where the AC coupling capacitor passes an AC component of the input voltage V_{IN}, and the DC bias resistor adds a DC bias (i.e., bias voltage V_{CM_N}) to the AC component V_{IN}, thus resulting in a gate voltage (V_{IN}+V_{CM_N}) at the gate terminal of the transistor MN2.

In this embodiment, the bias current and the output mean voltage are programmed independently. Regarding the biasing circuit 104, it includes a replica source follower 111, a current source 112, a low-pass filter 114, an error amplifier AMP1, and a capacitor C1. The replica source follower 111 corresponds to the transistor MP2 of the main source follower 102, and includes a transistor MP1, where the transistor MP1 is a PMOS transistor acting as a P-type source follower. The transistor MP1 has a gate terminal (which acts as a control terminal), a source terminal (which acts as a first connection terminal), and a drain terminal (which acts as a second connection terminal), where the bias voltage V_{CM_P} is generated at the gate terminal, and the drain terminal is coupled to a power rail on which the ground voltage GND is delivered. Specifically, the replica source follower 111 is a replica of the P-type source follower (i.e., transistor MP2) included in the main source follower 102, where a current-to-voltage (I-V) characteristic of the replica source follower 111 may be the same as that of the P-type source follower included in the main source follower 102. In some embodiments of the present invention, the replica source follower 111 (particularly, transistor MP1 of replica source follower 111) may be a scaled version of the P-type source follower in the main source follower 102 (particularly, transistor MP2 of main source follower 102). For example, the transistor MP1 may be a scaled-down version of the transistor MP2 for power saving and area saving. However, this is for illustrative purposes only, and is not meant to be a limitation of the present invention.

The error amplifier AMP1 has a first input terminal, a second input terminal, and an output terminal, where the first input terminal is coupled to the source terminal of the transistor MP1, the second input terminal is configured to receive an input voltage V_{DC1} indicative of the output mean voltage, and the output terminal is coupled to the gate terminal of the transistor MP1.

The low-pass filter 114 is coupled between the second input terminal of the error amplifier AMP1 and the output node N of the push-pull source follower circuit 100, and is configured to apply low-pass filtering to the output voltage V_{OUT} of the push-pull source follower circuit 100 for generating the input voltage V_{DC1}. Specifically, the low-pass filter output is a DC component of the output voltage V_{OUT}.

The current source 112 is coupled between the first input terminal of the error amplifier AMP1 and the power rail on which the supply voltage VDD is delivered, and is configured to provide a reference current I_{bias}. The reference current I_{bias} acts as a bias current flowing through the transistor MP1, such that an output voltage V_{REP_O} of the replica source follower 111 is established at the source terminal of the transistor MP1 under a condition that the bias voltage V_{CM_P} is applied to the gate terminal of the transistor MP1. The error amplifier AMP1 adaptively adjusts the bias voltage V_{CM_P} according to an error between the output voltage V_{REP_O} and the input voltage V_{DC1}. The bias voltage V_{CM_P} is held by the capacitor C1. Since the reference current I_{bias} flowing through the transistor MP1 has a constant current value, the output voltage (i.e., source voltage of transistor MP1) V_{REP_O} changes in response to a change of the bias voltage (i.e., gate voltage of transistor MP1) V_{CM_P}. In other words, the error amplifier AMP1 adaptively adjusts the bias voltage V_{CM_P} to minimize the error between the output voltage V_{REP_O} and the input voltage V_{DC1}. Hence, the error amplifier AMP1 will make the output voltage V_{REP_O} same as or close to the input voltage V_{DC1} that is the mean of the output voltage V_{OUT}.

Since the replica source follower 111 is a replica (e.g., scaled version) of the P-type source follower of the main source follower 102, a bias current of the main source follower 102 is also a replica (e.g., scaled version) of the reference current I_{bias} under a condition that gate terminals of transistors MP1 and MP2 are biased by the same bias voltage V_{CM_P}, drain terminals of transistors MP1 and MP2 are set by the same ground voltage GND, and source terminals of transistors MP1 and MP2 have the same DC voltage V_{REP_O} = V_{DC1} = mean of V_{OUT}. In this embodiment, the reference current I_{bias} is programmable, and the bias current of the main source follower 102 is set by programming the reference current I_{bias} provided by the current source 112. To put it simply, the reference current I_{bias} is one programmable parameter of the push-pull source follower circuit 100.

Regarding the biasing circuit 106, it includes an error amplifier AMP2, a low-pass filter 116, and a capacitor C2. The error amplifier AMP2 has a first input terminal, a second input terminal, and an output terminal, where the first input terminal is configured to receive an input voltage V_{DC2} indicative of a mean voltage, the second input terminal is configured to receive a reference voltage V_{REF}, and the bias voltage V_{CM_N} is generated at the output terminal.

In a first exemplary design of the biasing circuit 106, the low-pass filter 116 is coupled between the first input terminal of the error amplifier AMP2 and the output node N of the push-pull source follower circuit 100, and is configured to apply low-pass filtering to the output voltage V_{OUT} for generating the input voltage V_{DC2}. Specifically, the input voltage V_{DC2} is indicative of the output mean voltage due to the low-pass filter output being a DC component of the output voltage V_{OUT}.

As shown in FIG. 1, the output voltage V_{OUT} of the push-pull source follower circuit 100 is supplied to a next-stage circuit (denoted by "CKT_NXT") 10. Hence, the output voltage V_{OUT} of the push-pull source follower circuit 100 is received at an input node of the next-stage circuit 10, an internal-node voltage V_{INT1} is generated at an internal node of the next-stage circuit 10, and an output voltage V_{OUT2} is generated at an output node of the next-stage circuit 10. It should be noted that the next-stage circuit 10 may be any arbitrary circuit depending upon actual design considerations. For example, the next-stage circuit 10 may be an RLC network, a buffer circuit, or an amplifier circuit.

In a second exemplary design of the biasing circuit 106, the low-pass filter 116 is coupled between the first input terminal of the error amplifier AMP2 and the output node of the next-stage circuit 10, and is configured to apply low-pass filtering to the output voltage V_{OUT2} for generating the input voltage V_{DC2}. Specifically, the input voltage V_{DC2} is indicative of an output mean voltage of the next-stage circuit 10 due to the low-pass filter output being a DC component of the output voltage V_{OUT2}.

In a third exemplary design of the biasing circuit 106, the low-pass filter 116 is coupled between the first input terminal of the error amplifier AMP2 and the internal node of the next-stage circuit 10, and is configured to apply low-pass filtering to the internal-node voltage V_{INT1} for generating the input voltage V_{DC2}. Specifically, the input voltage V_{DC2} is indicative of an internal mean voltage of the next-stage circuit 10 due to the low-pass filter output being a DC component of the internal-node voltage V_{INT1}.

The error amplifier AMP2 adaptively adjusts the bias voltage V_{CM_N} according to an error between the reference voltage V_{REF} and the input voltage V_{DC2}. The bias voltage V_{CM_N} is held by the capacitor C2. Since the drain terminal of the transistor MN2 is coupled to a fixed voltage (i.e., supply voltage VDD), the input voltage V_{DC2} (e.g., mean voltage of V_{OUT}, V_{OUT2}, or V_{INT1}) changes in response to a change of the bias voltage (i.e., gate voltage of transistor MN2) V_{CM_N}. In other words, the error amplifier AMP2 adaptively adjusts the bias voltage V_{CM_N} to minimize the error between the reference voltage V_{REF} and the input voltage V_{DC2}. Hence, the error amplifier AMP2 will make the input voltage V_{DC2} (e.g., mean voltage of V_{OUT}, V_{OUT2}, or V_{INT1}) same as or close to the reference voltage V_{REF}.

Since the internal-node voltage V_{INT1} and the output voltage V_{OUT2} of the next-stage circuit 10 are derived from the output voltage V_{OUT} of the preceding push-pull source follower circuit 100, the mean of the internal-node voltage V_{INT1} and the output voltage V_{OUT2} can be set by controlling the output mean voltage of the preceding push-pull source follower circuit 100. In this embodiment, the reference voltage V_{REF} is programmable, and the output mean voltage of the push-pull source follower circuit 100 is set by programming the reference voltage V_{REF} provided by a voltage generator (not shown). To put it simply, the reference voltage V_{REF} is another programmable parameter of the push-pull source follower circuit 100. If the mean of the output voltage V_{OUT} of the push-pull source follower circuit 100 (i.e., the mean of the input voltage of the next-stage circuit 10) is concerned, the low-pass filter 116 is configured to receive the output voltage V_{OUT} as its filter input. If the mean of the internal-node voltage V_{INT1} of the next-stage circuit 10 is concerned, the low-pass filter 116 is configured to receive the internal-node voltage V_{INT1} as its filter input. If the mean of the output voltage V_{OUT2} of the next-stage circuit 10 is concerned, the low-pass filter 116 is configured to receive the output voltage V_{OUT2} as its filter input.

Regarding the push-pull source follower circuit 100, the biasing circuit 104 is used to set the bias voltage V_{CM_P} of the P-type source follower of the main source follower 102, and the biasing circuit 106 is used to set the bias voltage V_{CM_N} of the N-type source follower of the main source follower 102. However, this is for illustrative purposes only, and is not meant to be a limitation of the present invention. Alternatively, roles of the biasing circuits 104 and 106 may be swapped.

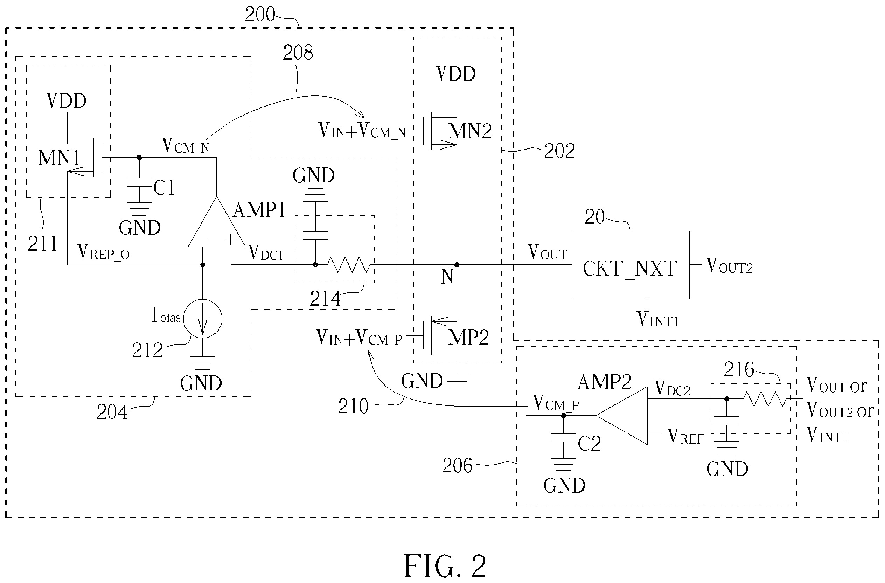

FIG. 2 is a diagram illustrating a second push-pull source follower design using the proposed biasing technique according to an embodiment of the present invention. The push-pull source follower circuit 200 is based on a complementary structure, and adopts the proposed biasing technique to independently program a bias current and an output mean voltage. In this embodiment, the push-pull source follower circuit 200 includes a main source follower 202 and a plurality of biasing circuits 204 and 206. The main source follower 202 includes transistors MN2 and MP2, where the transistor MN2 is an NMOS transistor acting as an N-type source follower, and the transistor MP2 is a PMOS transistor acting as a P-type source follower. The transistor MN2 has a gate terminal (which acts as a control terminal), a source terminal (which acts as a first connection terminal), and a drain terminal (which acts as a second connection terminal), where the source terminal is coupled to an output node N of the push-pull source follower circuit 200, and the drain terminal is coupled to a power rail on which a supply voltage VDD is delivered. The transistor MP2 has a gate terminal (which acts as a control terminal), a source terminal (which acts as a first connection terminal, and a drain terminal (which acts as a second connection terminal), where the source terminal is coupled to the output node N of the push-pull source follower circuit 200, and the drain terminal is coupled to a power rail on which a ground voltage GND is delivered.

The biasing circuit 204 is configured to program a bias current of the main source follower 202 through generating and outputting a bias voltage V_{CM_N} to the gate terminal of the transistor MN2. The bias voltage V_{CM_N} may be supplied to the gate terminal of the transistor MN2 through a coupling circuit 208 such as an active coupler or a passive coupler. For example, the coupling circuit 208 may be implemented using a DC level shifter including an AC coupling capacitor and a DC bias resistor, where the AC coupling capacitor passes an AC component of an input voltage V_{IN}, and the DC bias resistor adds a DC bias (i.e., bias voltage V_{CM_N}) to the AC component V_{IN}, thus resulting in a gate voltage (V_{IN}+V_{CM_N}) at the gate terminal of the transistor MN2.

The biasing circuit 206 is configured to program an output mean voltage (i.e., a DC level of an output voltage V_{OUT}) of the push-pull source follower circuit 200 through generating and outputting a bias voltage V_{CM_P} to the gate terminal of the transistor MP2. The bias voltage V_{CM_P} may be supplied to the gate terminal of the transistor MP2 through a coupling circuit 210 such as an active coupler or a passive coupler. For example, the coupling circuit 210 may be implemented using a DC level shifter including an AC coupling capacitor and a DC bias resistor, where the AC coupling capacitor passes an AC component of the input voltage V_{IN}, and the DC bias resistor adds a DC bias (i.e., bias voltage V_{CM_P}) to the AC component V_{IN}, thus resulting in a gate voltage (V_{IN}+V_{CM_P}) at the gate terminal of the transistor MP2.

In this embodiment, the bias current and the output mean voltage are programmed independently. Regarding the biasing circuit 204, it includes a replica source follower 211, a current source 212, a low-pass filter 214, an error amplifier AMP1, and a capacitor C1. The replica source follower 211 corresponds to the transistor MN2 of the main source follower 202, and includes a transistor MN1, where the transistor MN1 is an NMOS transistor acting as an N-type source follower. The transistor MN1 has a gate terminal (which acts as a control terminal), a source terminal (which acts as a first connection terminal), and a drain terminal (which acts as a second connection terminal), where the bias voltage V_{CM_N} is generated at the gate terminal, and the drain terminal is coupled to the power rail on which the supply voltage VDD is delivered. Specifically, the replica source follower 211 is a replica of the N-type source follower (i.e., transistor MN2) included in the main source follower 202, where an I-V characteristic of the replica source follower 211 may be the same as that of the N-type source follower included in the main source follower 202. In some embodiments of the present invention, the replica source follower 211 (particularly, transistor MN1 of replica source follower 211) may be a scaled version of the N-type source follower in the main source follower 202 (particularly, transistor MN2 of main source follower 202). For example, the transistor MN1 may be a scaled-down version of the transistor MN2 for power saving and area saving. However, this is for illustrative purposes only, and is not meant to be a limitation of the present invention.

The error amplifier AMP1 has a first input terminal, a second input terminal, and an output terminal, where the first input terminal is coupled to the source terminal of the transistor MN1, the second input terminal is configured to receive an input voltage V_{DC1} indicative of the output mean voltage, and the output terminal is coupled to the gate terminal of the transistor MN1.

The low-pass filter 214 is coupled between the second input terminal of the error amplifier AMP1 and the output node N of the push-pull source follower circuit 200, and is configured to apply low-pass filtering to the output voltage V_{OUT} of the push-pull source follower circuit 200 for generating the input voltage V_{DC1}. Specifically, the low-pass filter output is a DC component of the output voltage V_{OUT}.

The current source 212 is coupled between the first input terminal of the error amplifier AMP1 and the power rail on which the ground voltage GND is delivered, and is configured to provide a reference current I_{bias}. The reference current I_{bias} acts as a bias current flowing through the transistor MN1, such that an output voltage V_{REP_O} of the replica source follower 211 is established at the source terminal of the transistor MN1 under a condition that the bias voltage V_{CM_N} is applied to the gate terminal of the transistor MN1. The error amplifier AMP1 adaptively adjusts the bias voltage V_{CM_N} according to an error between the output voltage V_{REP_O} and the input voltage V_{DC1}. The bias voltage V_{CM_N} is held by the capacitor C1. Since the reference current I_{bias} flowing through the transistor MN1 has a constant current value, the output voltage (i.e., source voltage of transistor MN1) V_{REP_O} changes in response to a change of the bias voltage (i.e., gate voltage of transistor MN1) V_{CM_N}. In other words, the error amplifier AMP1 adaptively adjusts the bias voltage V_{CM_N} to minimize the error between the output voltage V_{REP_O} and the input voltage V_{DC1}. Hence, the error amplifier AMP1 will make the output voltage V_{REP_O} same as or close to the input voltage V_{DC1} that is the mean of the output voltage V_{OUT}.

Since the replica source follower 211 is a replica (e.g., scaled version) of the N-type source follower of the main source follower 202, a bias current of the main source follower 202 is also a replica (e.g., scaled version) of the reference current I_{bias} under a condition that gate terminals of transistors MN1 and MN2 are biased by the same bias voltage V_{CM_N}, drain terminals of transistors MN1 and MN2 are set by the same supply voltage VDD, and source terminals of transistors MN1 and MN2 have the same DC voltage V_{REP_O} = V_{DC1} = mean of V_{OUT}. In this embodiment, the reference current I_{bias} is programmable, and the bias current of the main source follower 202 is set by programming the reference current I_{bias} provided by the current source 212. To put it simply, the reference current I_{bias} is one programmable parameter of the push-pull source follower circuit 200.

Regarding the biasing circuit 206, it includes an error amplifier AMP2, a low-pass filter 216, and a capacitor C2. The error amplifier AMP2 has a first input terminal, a second input terminal, and an output terminal, where the first input terminal is configured to receive an input voltage V_{DC2} indicative of a mean voltage, the second input terminal is configured to receive a reference voltage V_{REF}, and the bias voltage V_{CM_P} is generated at the output terminal.

In a first exemplary design of the biasing circuit 206, the low-pass filter 216 is coupled between the first input terminal of the error amplifier AMP2 and the output node N of the push-pull source follower circuit 200, and is configured to apply low-pass filtering to the output voltage V_{OUT} for generating the input voltage V_{DC2}. Specifically, the input voltage V_{DC2} is indicative of the output mean voltage due to the low-pass filter output being a DC component of the output voltage V_{OUT}.

As shown in FIG. 2, the output voltage V_{OUT} of the push-pull source follower circuit 200 is supplied to a next-stage circuit (denoted by "CKT_NXT") 20. Hence, the output voltage V_{OUT} of the push-pull source follower circuit 200 is received at an input node of the next-stage circuit 20, an internal-node voltage V_{INT1} is generated at an internal node of the next-stage circuit 20, and an output voltage V_{OUT2} is generated at an output node of the next-stage circuit 20. It should be noted that the next-stage circuit 20 may be any arbitrary circuit depending upon actual design considerations. For example, the next-stage circuit 20 may be an RLC network, a buffer circuit, or an amplifier circuit.

In a second exemplary design of the biasing circuit 206, the low-pass filter 216 is coupled between the first input terminal of the error amplifier AMP2 and the output node of the next-stage circuit 20, and is configured to apply low-pass filtering to the output voltage V_{OUT2} for generating the input voltage V_{DC2}. Specifically, the input voltage V_{DC2} is indicative of an output mean voltage of the next-stage circuit 20 due to the low-pass filter output being a DC component of the output voltage V_{OUT2}.

In a third exemplary design of the biasing circuit 206, the low-pass filter 216 is coupled between the first input terminal of the error amplifier AMP2 and the internal node of the next-stage circuit 20, and is configured to apply low-pass filtering to the internal-node voltage V_{INT1} for generating the input voltage V_{DC2}. Specifically, the input voltage V_{DC2} is indicative of an internal mean voltage of the next-stage circuit 20 due to the low-pass filter output being a DC component of the internal-node voltage V_{INT1}.

The error amplifier AMP2 adaptively adjusts the bias voltage V_{CM_P} according to an error between the reference voltage V_{REF} and the input voltage V_{DC2}. The bias voltage V_{CM_P} is held by the capacitor C2. Since the drain terminal of the transistor MN2 is coupled to a fixed voltage (i.e., ground voltage GND), the input voltage V_{DC2} (e.g., mean voltage of V_{OUT}, V_{OUT2}, or V_{INT1}) changes in response to a change of the bias voltage (i.e., gate voltage of transistor MP2) V_{CM_P}. In other words, the error amplifier AMP2 adaptively adjusts the bias voltage V_{CM_P} to minimize the error between the reference voltage V_{REF} and the input voltage V_{DC2}. Hence, the error amplifier AMP2 will make the input voltage V_{DC2} (e.g., mean voltage of V_{OUT}, V_{OUT2}, or V_{INT1}) same as or close to the reference voltage V_{REF}.

Since the internal-node voltage V_{INT1} and the output voltage V_{OUT2} of the next-stage circuit 20 are derived from the output voltage V_{OUT} of the preceding push-pull source follower circuit 200, the mean of the internal-node voltage V_{INT1} and the output voltage V_{OUT2} can be set by controlling the output mean voltage of the preceding push-pull source follower circuit 200. In this embodiment, the reference voltage V_{REF} is programmable, and the output mean voltage of the push-pull source follower circuit 200 is set by programming the reference voltage V_{REF} provided by a voltage generator (not shown). To put it simply, the reference voltage V_{REF} is another programmable parameter of the push-pull source follower circuit 200. If the mean of the output voltage V_{OUT} of the push-pull source follower circuit 200 (i.e., the mean of the input voltage of the next-stage circuit 20) is concerned, the low-pass filter 216 is configured to receive the output voltage V_{OUT} as its filter input. If the mean of the internal-node voltage V_{INT1} of the next-stage circuit 20 is concerned, the low-pass filter 216 is configured to receive the internal-node voltage V_{INT1} as its filter input. If the mean of the output voltage V_{OUT2} of the next-stage circuit 20 is concerned, the low-pass filter 216 is configured to receive the output voltage V_{OUT2} as its filter input.

Regarding the push-pull source follower circuit 100/200, the error amplifier AMP1 of the biasing circuit 104/204 obtains the output mean voltage as the input voltage V_{DC1} through the low-pass filter 114/214. However, this is for illustrative purposes only, and is not meant to be a limitation of the present invention. Alternatively, an output mean voltage referenced by the error amplifier AMP1 of one biasing circuit for biasing current control may be directly set by a reference voltage which is referenced by the error amplifier AMP2 of another biasing circuit for output mean voltage control.

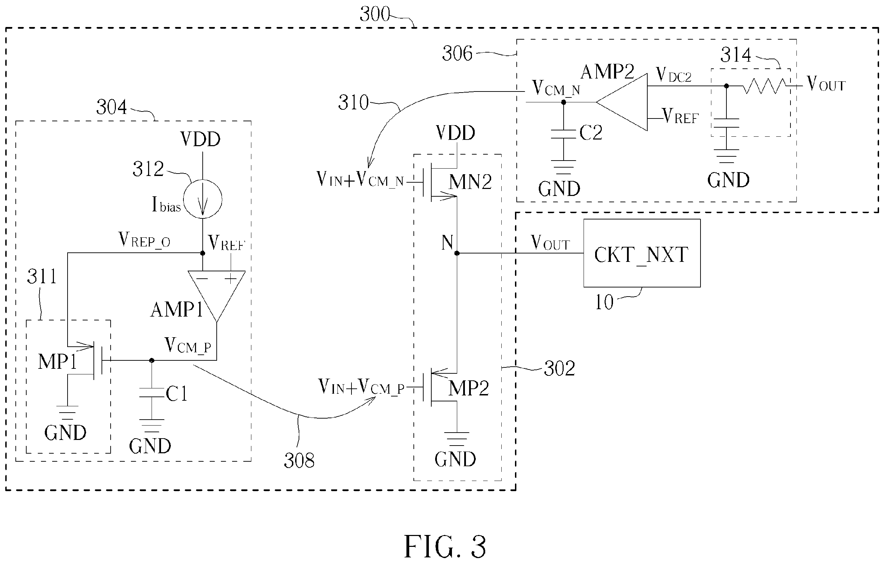

FIG. 3 is a diagram illustrating a third push-pull source follower design using the proposed biasing technique according to an embodiment of the present invention. The push-pull source follower circuit 300 is based on a complementary structure, and adopts the proposed biasing technique to independently program a bias current and an output mean voltage. In this embodiment, the push-pull source follower circuit 300 includes a main source follower 302 and a plurality of biasing circuits 304 and 306. The main source follower 302 includes transistors MN2 and MP2, where the transistor MN2 is an NMOS transistor acting as an N-type source follower, and the transistor MP2 is a PMOS transistor acting as a P-type source follower. The transistor MN2 has a gate terminal (which acts as a control terminal), a source terminal (which acts as a first connection terminal), and a drain terminal (which acts as a second connection terminal), where the source terminal is coupled to an output node N of the push-pull source follower circuit 300, and the drain terminal is coupled to a power rail on which a supply voltage VDD is delivered. The transistor MP2 has a gate terminal (which acts as a control terminal), a source terminal (which acts as a first connection terminal, and a drain terminal (which acts as a second connection terminal), where the source terminal is coupled to the output node N of the push-pull source follower circuit 300, and the drain terminal is coupled to a power rail on which a ground voltage GND is delivered.

The biasing circuit 304 is configured to program a bias current of the main source follower 302 through generating and outputting a bias voltage V_{CM_P} to the gate terminal of the transistor MP2. The bias voltage V_{CM_P} may be supplied to the gate terminal of the transistor MP2 through a coupling circuit 308 such as an active coupler or a passive coupler. For example, the coupling circuit 308 may be implemented using a DC level shifter including an AC coupling capacitor and a DC bias resistor, where the AC coupling capacitor passes an AC component of an input voltage V_{IN}, and the DC bias resistor adds a DC bias (i.e., bias voltage V_{CM_P}) to the AC component V_{IN}, thus resulting in a gate voltage (V_{IN}+V_{CM_P}) at the gate terminal of the transistor MP2.

The biasing circuit 306 is configured to program an output mean voltage (i.e., a DC level of an output voltage V_{OUT}) of the push-pull source follower circuit 300 through generating and outputting a bias voltage V_{CM_N} to the gate terminal of the transistor MN2. The bias voltage V_{CM_N} may be supplied to the gate terminal of the transistor MN2 through a coupling circuit 310 such as an active coupler or a passive coupler. For example, the coupling circuit 310 may be implemented using a DC level shifter including an AC coupling capacitor and a DC bias resistor, where the AC coupling capacitor passes an AC component of the input voltage V_{IN}, and the DC bias resistor adds a DC bias (i.e., bias voltage V_{CM_N}) to the AC component V_{IN}, thus resulting in a gate voltage (V_{IN}+V_{CM_N}) at the gate terminal of the transistor MN2.

In this embodiment, the bias current and the output mean voltage are programmed independently. Regarding the biasing circuit 306, it includes an error amplifier AMP2, a low-pass filter 314, and a capacitor C2. The error amplifier AMP2 has a first input terminal, a second input terminal, and an output terminal, where the first input terminal is configured to receive an input voltage V_{DC2} indicative of a mean voltage, the second input terminal is configured to receive a reference voltage V_{REF}, and the bias voltage V_{CM_N} is generated at the output terminal. The major difference between the biasing circuits 106 and 306 is that a source of the input voltage V_{DC2} has only a single choice being the output voltage V_{OUT} of the push-pull source follower circuit 300 since the reference voltage V_{REF} is also used by the biasing circuit 304 for indicating the output mean voltage of the push-pull source follower circuit 300. As shown in FIG. 3, the low-pass filter 314 is coupled between the first input terminal of the error amplifier AMP2 and the output node N of the push-pull source follower circuit 300, and is configured to apply low-pass filtering to the output voltage V_{OUT} for generating the input voltage V_{DC2}. Specifically, the input voltage V_{DC2} is indicative of the output mean voltage due to the low-pass filter output being a DC component of the output voltage V_{OUT}.

The error amplifier AMP2 adaptively adjusts the bias voltage V_{CM_N} according to an error between the reference voltage V_{REF} and the input voltage V_{DC2}. The bias voltage V_{CM_N} is held by the capacitor C2. Since the drain terminal of the transistor MN2 is coupled to a fixed voltage (i.e., supply voltage VDD), the input voltage V_{DC2} (e.g., mean voltage of V_{OUT}) changes in response to a change of the bias voltage (i.e., gate voltage of transistor MN2) V_{CM_N}. In other words, the error amplifier AMP2 adaptively adjusts the bias voltage V_{CM_N} to minimize the error between the reference voltage V_{REF} and the input voltage V_{DC2}. Hence, the error amplifier AMP2 will make the input voltage V_{DC2} (e.g., mean voltage of V_{OUT}) same as or close to the reference voltage V_{REF}. In this embodiment, the reference voltage V_{REF} is programmable, and the output mean voltage of the push-pull source follower circuit 300 is set by programming the reference voltage V_{REF} provided by a voltage generator (not shown). To put it simply, the reference voltage V_{REF} is one programmable parameter of the push-pull source follower circuit 300.

Regarding the biasing circuit 304, it includes a replica source follower 311, a current source 312, an error amplifier AMP1, and a capacitor C1. The replica source follower 311 corresponds to the transistor MP2 of the main source follower 302, and includes a transistor MP1, where the transistor MP1 is a PMOS transistor acting as a P-type source follower. The transistor MP1 has a gate terminal (which acts as a control terminal), a source terminal (which acts as a first connection terminal), and a drain terminal (which acts as a second connection terminal), where the bias voltage V_{CM_P} is generated at the gate terminal, and the drain terminal is coupled to the power rail on which the ground voltage GND is delivered. Specifically, the replica source follower 311 is a replica of the P-type source follower (i.e., transistor MP2) included in the main source follower 302, where an I-V characteristic of the replica source follower 311 may be the same as that of the P-type source follower included in the main source follower 302. In some embodiments of the present invention, the replica source follower 311 (particularly, transistor MP1 of replica source follower 311) may be a scaled version of the P-type source follower in the main source follower 302 (particularly, transistor MP2 of main source follower 302). For example, the transistor MP1 may be a scaled-down version of the transistor MP2 for power saving and area saving. However, this is for illustrative purposes only, and is not meant to be a limitation of the present invention.

The error amplifier AMP1 has a first input terminal, a second input terminal, and an output terminal. The major difference between the biasing circuits 104 and 304 is that the biasing circuit 304 has no low-pass filter coupled between the second input terminal of the error amplifier AMP1 and the output node N of the push-pull source follower circuit 300. As shown in FIG. 3, the first input terminal of the error amplifier AMP1 is coupled to the source terminal of the transistor MP1, the second input terminal is configured to receive the same reference voltage V_{REF} used by the error amplifier AMP2, and the output terminal of the error amplifier AMP1 is coupled to the gate terminal of the transistor MP1.

The current source 312 is coupled between the first input terminal of the error amplifier AMP1 and the power rail on which the supply voltage VDD is delivered, and is configured to provide a reference current I_{bias}. The reference current I_{bias} acts as a bias current flowing through the transistor MP1, such that an output voltage V_{REP_O} of the replica source follower 311 is established at the source terminal of the transistor MP1 under a condition that the bias voltage V_{CM_P} is applied to the gate terminal of the transistor MP1. The error amplifier AMP1 adaptively adjusts the bias voltage V_{CM_P} according to an error between the output voltage V_{REP_O} and the reference voltage V_{REF} (which is a target level of the output mean voltage). The bias voltage V_{CM_P} is held by the capacitor C1. Since the reference current I_{bias} flowing through the transistor MP1 has a constant current value, the output voltage (i.e., source voltage of transistor MP1) V_{REP_O} changes in response to a change of the bias voltage (i.e., gate voltage of transistor MP1) V_{CM_P}. In other words, the error amplifier AMP1 adaptively adjusts the bias voltage V_{CM_P} to minimize the error between the output voltage V_{REP_O} and the reference voltage V_{REF}. Hence, the error amplifier AMP1 will make the output voltage V_{REP_O} same as or close to the reference voltage V_{REF}.

Since the replica source follower 311 is a replica (e.g., scaled version) of the P-type source follower of the main source follower 302, a bias current of the main source follower 302 is also a replica (e.g., scaled version) of the reference current I_{bias} under a condition that gate terminals of transistors MP1 and MP2 are biased by the same bias voltage V_{CM_P}, drain terminals of transistors MP1 and MP2 are set by the same ground voltage GND, and source terminals of transistors MP1 and MP2 have the same DC voltage V_{REP_O} = V_{REF} = mean of V_{OUT}. In this embodiment, the reference current I_{bias} is programmable, and the bias current of the main source follower 302 is set by programming the reference current I_{bias} provided by the current source 312. To put it simply, the reference current I_{bias} is another programmable parameter of the push-pull source follower circuit 300.

Regarding the push-pull source follower circuit 300, the biasing circuit 304 is used to set the bias voltage V_{CM_P} of the P-type source follower of the main source follower 302, and the biasing circuit 306 is used to set the bias voltage V_{CM_N} of the N-type source follower of the main source follower 302. However, this is for illustrative purposes only, and is not meant to be a limitation of the present invention. Alternatively, roles of the biasing circuits 304 and 306 may be swapped.

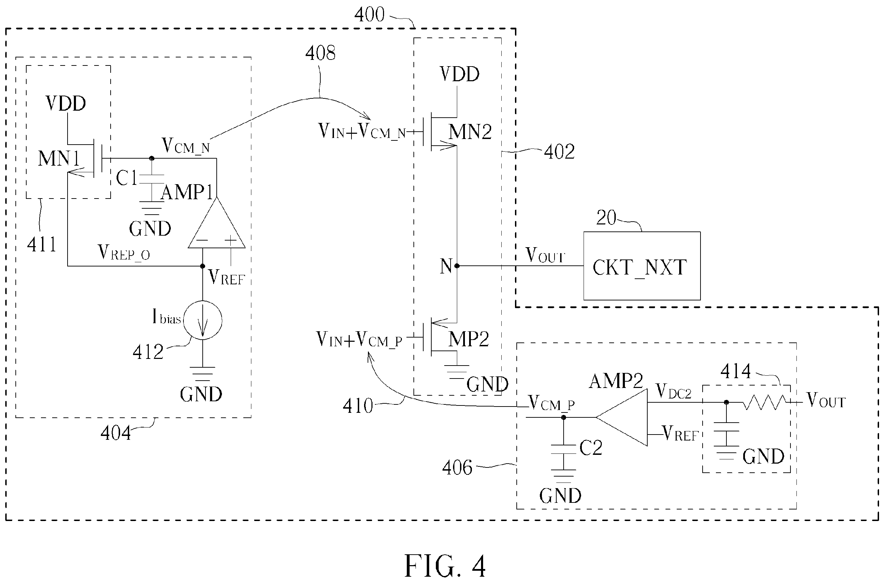

FIG. 4 is a diagram illustrating a fourth push-pull source follower design using the proposed biasing technique according to an embodiment of the present invention. The push-pull source follower circuit 400 is based on a complementary structure, and adopts the proposed biasing technique to independently program a bias current and an output mean voltage. In this embodiment, the push-pull source follower circuit 400 includes a main source follower 402 and a plurality of biasing circuits 404 and 406. The main source follower 402 includes transistors MN2 and MP2, where the transistor MN2 is an NMOS transistor acting as an N-type source follower, and the transistor MP2 is a PMOS transistor acting as a P-type source follower. The transistor MN2 has a gate terminal (which acts as a control terminal), a source terminal (which acts as a first connection terminal), and a drain terminal (which acts as a second connection terminal), where the source terminal is coupled to an output node N of the push-pull source follower circuit 400, and the drain terminal is coupled to a power rail on which a supply voltage VDD is delivered. The transistor MP2 has a gate terminal (which acts as a control terminal), a source terminal (which acts as a first connection terminal, and a drain terminal (which acts as a second connection terminal), where the source terminal is coupled to the output node N of the push-pull source follower circuit 400, and the drain terminal is coupled to a power rail on which a ground voltage GND is delivered.

The biasing circuit 404 is configured to program a bias current of the main source follower 402 through generating and outputting a bias voltage V_{CM_N} to the gate terminal of the transistor MN2. The bias voltage V_{CM_N} may be supplied to the gate terminal of the transistor MN2 through a coupling circuit 408 such as an active coupler or a passive coupler. For example, the coupling circuit 408 may be implemented using a DC level shifter including an AC coupling capacitor and a DC bias resistor, where the AC coupling capacitor passes an AC component of an input voltage V_{IN}, and the DC bias resistor adds a DC bias (i.e., bias voltage V_{CM_N}) to the AC component V_{IN}, thus resulting in a gate voltage (V_{IN}+V_{CM_N}) at the gate terminal of the transistor MN2.

The biasing circuit 306 is configured to program an output mean voltage (i.e., a DC level of an output voltage V_{OUT}) of the push-pull source follower circuit 400 through generating and outputting a bias voltage V_{CM_P} to the gate terminal of the transistor MP2. The bias voltage V_{CM_P} may be supplied to the gate terminal of the transistor MP2 through a coupling circuit 410 such as an active coupler or a passive coupler. For example, the coupling circuit 410 may be implemented using a DC level shifter including an AC coupling capacitor and a DC bias resistor, where the AC coupling capacitor passes an AC component of the input voltage V_{IN}, and the DC bias resistor adds a DC bias (i.e., bias voltage V_{CM_P}) to the AC component V_{IN}, thus resulting in a gate voltage (V_{IN}+V_{CM_P}) at the gate terminal of the transistor MP2.

In this embodiment, the bias current and the output mean voltage are programmed independently. Regarding the biasing circuit 406, it includes an error amplifier AMP2, a low-pass filter 414, and a capacitor C2. The error amplifier AMP2 has a first input terminal, a second input terminal, and an output terminal, where the first input terminal is configured to receive an input voltage V_{DC2} indicative of a mean voltage, the second input terminal is configured to receive a reference voltage V_{REF}, and the bias voltage V_{CM_P} is generated at the output terminal. The major difference between the biasing circuits 106 and 406 is that a source of the input voltage V_{DC2} has only a single choice being the output voltage V_{OUT} of the push-pull source follower circuit 400 since the reference voltage V_{REF} is also used by the biasing circuit 404 for indicating the output mean voltage of the push-pull source follower circuit 400. As shown in FIG. 4, the low-pass filter 414 is coupled between the first input terminal of the error amplifier AMP2 and the output node N of the push-pull source follower circuit 400, and is configured to apply low-pass filtering to the output voltage V_{OUT} for generating the input voltage V_{DC2}. Specifically, the input voltage V_{DC2} is indicative of the output mean voltage due to the low-pass filter output being a DC component of the output voltage V_{OUT}.

The error amplifier AMP2 adaptively adjusts the bias voltage V_{CM_P} according to an error between the reference voltage V_{REF} and the input voltage V_{DC2}. The bias voltage V_{CM_P} is held by the capacitor C2. Since the drain terminal of the transistor MP2 is coupled to a fixed voltage (i.e., ground voltage GND), the input voltage V_{DC2} (e.g., mean voltage of V_{OUT}) changes in response to a change of the bias voltage (i.e., gate voltage of transistor MP2) V_{CM_P}. In other words, the error amplifier AMP2 adaptively adjusts the bias voltage V_{CM_P} to minimize the error between the reference voltage V_{REF} and the input voltage V_{DC2}. Hence, the error amplifier AMP2 will make the input voltage V_{DC2} (e.g., mean voltage of V_{OUT}) same as or close to the reference voltage V_{REF}. In this embodiment, the reference voltage V_{REF} is programmable, and the output mean voltage of the push-pull source follower circuit 400 is set by programming the reference voltage V_{REF} provided by a voltage generator (not shown). To put it simply, the reference voltage V_{REF} is one programmable parameter of the push-pull source follower circuit 400.

Regarding the biasing circuit 404, it includes a replica source follower 411, a current source 412, an error amplifier AMP1, and a capacitor C1. The replica source follower 411 corresponds to the transistor MN2 of the main source follower 402, and includes a transistor MN1, where the transistor MN1 is an NMOS transistor acting as an N-type source follower. The transistor MN1 has a gate terminal (which acts as a control terminal), a source terminal (which acts as a first connection terminal), and a drain terminal (which acts as a second connection terminal), where the bias voltage V_{CM_N} is generated at the gate terminal, and the drain terminal is coupled to the power rail on which the supply voltage VDD is delivered. Specifically, the replica source follower 411 is a replica of the N-type source follower (i.e., transistor MN2) included in the main source follower 402, where an I-V characteristic of the replica source follower 411 may be the same as that of the N-type source follower included in the main source follower 402. In some embodiments of the present invention, the replica source follower 411 (particularly, transistor MN1 of replica source follower 411) may be a scaled version of the N-type source follower in the main source follower 402 (particularly, transistor MN2 of main source follower 402). For example, the transistor MN1 may be a scaled-down version of the transistor MN2 for power saving and area saving. However, this is for illustrative purposes only, and is not meant to be a limitation of the present invention.

The error amplifier AMP1 has a first input terminal, a second input terminal, and an output terminal. The major difference between the biasing circuits 104 and 404 is that the biasing circuit 404 has no low-pass filter coupled between the second input terminal of the error amplifier AMP1 and the output node N of the push-pull source follower circuit 400. As shown in FIG. 4, the first input terminal of the error amplifier AMP1 is coupled to the source terminal of the transistor MN1, the second input terminal is configured to receive the same reference voltage V_{REF} used by the error amplifier AMP2, and the output terminal of the error amplifier AMP1 is coupled to the gate terminal of the transistor MN1.

The current source 412 is coupled between the first input terminal of the error amplifier AMP1 and the power rail on which the ground voltage GND is delivered, and is configured to provide a reference current I_{bias}. The reference current I_{bias} acts as a bias current flowing through the transistor MN1, such that an output voltage V_{REP_O} of the replica source follower 411 is established at the source terminal of the transistor MN1 under a condition that the bias voltage V_{CM_N} is applied to the gate terminal of the transistor MN1. The error amplifier AMP1 adaptively adjusts the bias voltage V_{CM_N} according to an error between the output voltage V_{REP_O} and the reference voltage V_{REF} (which is a target level of the output mean voltage). The bias voltage V_{CM_N} is held by the capacitor C1. Since the reference current I_{bias} flowing through the transistor MN1 has a constant current value, the output voltage (i.e., source voltage of transistor MN1) V_{REP_O} changes in response to a change of the bias voltage (i.e., gate voltage of transistor MN1) V_{CM_N}. In other words, the error amplifier AMP1 adaptively adjusts the bias voltage V_{CM_N} to minimize the error between the output voltage V_{REP_O} and the reference voltage V_{REF}. Hence, the error amplifier AMP1 will make the output voltage V_{REP_O} same as or close to the reference voltage V_{REF}.

Since the replica source follower 411 is a replica (e.g., scaled version) of the N-type source follower of the main source follower 402, a bias current of the main source follower 402 is also a replica (e.g., scaled version) of the reference current I_{bias} under a condition that gate terminals of transistors MN1 and MN2 are biased by the same bias voltage V_{CM_N}, drain terminals of transistors MN1 and MN2 are set by the same supply voltage VDD, and source terminals of transistors MN1 and MN2 have the same DC voltage V_{REP_O} = V_{REF} = mean of V_{OUT}. In this embodiment, the reference current I_{bias} is programmable, and the bias current of the main source follower 402 is set by programming the reference current I_{bias} provided by the current source 412. To put it simply, the reference current I_{bias} is another programmable parameter of the push-pull source follower circuit 400.

Regarding the push-pull source follower circuit 300/400, an output mean voltage referenced by the error amplifier AMP1 of one biasing circuit 304/404 for biasing current control is directly set by a reference voltage V_{REF} which is referenced by the error amplifier AMP2 of another biasing circuit 306/406 for output mean voltage control. However, this is for illustrative purposes only, and is not meant to be a limitation of the present invention. Alternatively, an output mean voltage referenced by the error amplifier AMP1 of one biasing circuit for biasing current control may be directly set by a reference voltage V_{REF} which is supplied to a replica next-stage circuit for creating another reference voltage referenced by the error amplifier AMP2 of another biasing circuit for output mean voltage control.

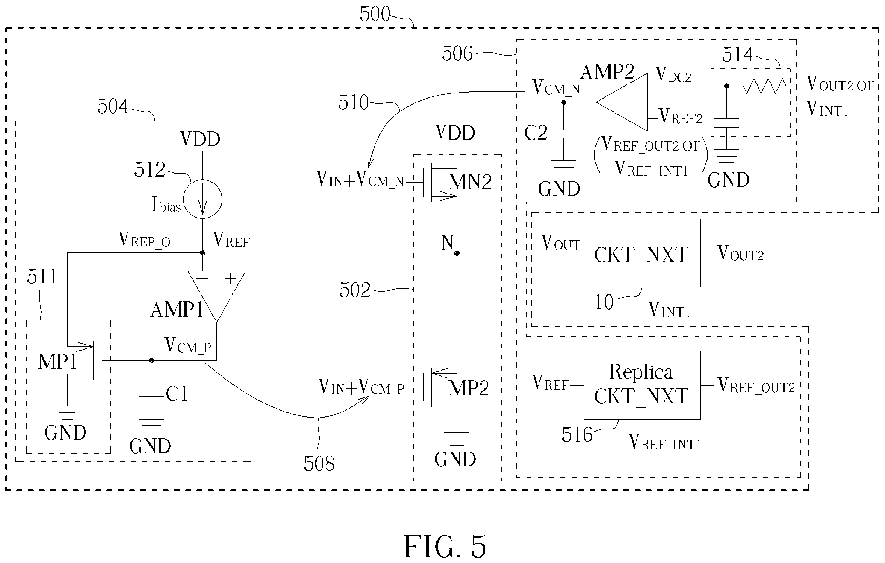

FIG. 5 is a diagram illustrating a fifth push-pull source follower design using the proposed biasing technique according to an embodiment of the present invention. The push-pull source follower circuit 500 is based on a complementary structure, and adopts the proposed biasing technique to independently program a bias current and an output mean voltage. In this embodiment, the push-pull source follower circuit 500 includes a main source follower 502 and a plurality of biasing circuits 504 and 506. The main source follower 502 includes transistors MN2 and MP2, where the transistor MN2 is an NMOS transistor acting as an N-type source follower, and the transistor MP2 is a PMOS transistor acting as a P-type source follower. The transistor MN2 has a gate terminal (which acts as a control terminal), a source terminal (which acts as a first connection terminal), and a drain terminal (which acts as a second connection terminal), where the source terminal is coupled to an output node N of the push-pull source follower circuit 500, and the drain terminal is coupled to a power rail on which a supply voltage VDD is delivered. The transistor MP2 has a gate terminal (which acts as a control terminal), a source terminal (which acts as a first connection terminal, and a drain terminal (which acts as a second connection terminal), where the source terminal is coupled to the output node N of the push-pull source follower circuit 500, and the drain terminal is coupled to a power rail on which a ground voltage GND is delivered.

The biasing circuit 504 is configured to program a bias current of the main source follower 502 through generating and outputting a bias voltage V_{CM_P} to the gate terminal of the transistor MP2. The bias voltage V_{CM_P} may be supplied to the gate terminal of the transistor MP2 through a coupling circuit 508 such as an active coupler or a passive coupler. For example, the coupling circuit 508 may be implemented using a DC level shifter including an AC coupling capacitor and a DC bias resistor, where the AC coupling capacitor passes an AC component of an input voltage V_{IN}, and the DC bias resistor adds a DC bias (i.e., bias voltage V_{CM_P}) to the AC component V_{IN}, thus resulting in a gate voltage (V_{IN}+V_{CM_P}) at the gate terminal of the transistor MP2.

The biasing circuit 506 is configured to program an output mean voltage (i.e., a DC level of an output voltage V_{OUT}) of the push-pull source follower circuit 500 through generating and outputting a bias voltage V_{CM_N} to the gate terminal of the transistor MN2. The bias voltage V_{CM_N} may be supplied to the gate terminal of the transistor MN2 through a coupling circuit 510 such as an active coupler or a passive coupler. For example, the coupling circuit 510 may be implemented using a DC level shifter including an AC coupling capacitor and a DC bias resistor, where the AC coupling capacitor passes an AC component of the input voltage V_{IN}, and the DC bias resistor adds a DC bias (i.e., bias voltage V_{CM_N}) to the AC component V_{IN}, thus resulting in a gate voltage (V_{IN}+V_{CM_N}) at the gate terminal of the transistor MN2.

As shown in FIG. 5, the output voltage V_{OUT} of the push-pull source follower circuit 500 is supplied to a next-stage circuit (denoted by "CKT_NXT") 10. Hence, the output voltage V_{OUT} of the push-pull source follower circuit 500 is received at an input node of the next-stage circuit 10, an internal-node voltage V_{INT1} is generated at an internal node of the next-stage circuit 10, and an output voltage V_{OUT2} is generated at an output node of the next-stage circuit 10. It should be noted that the next-stage circuit 10 may be any arbitrary circuit depending upon actual design considerations. For example, the next-stage circuit 10 may be an RLC network, a buffer circuit, or an amplifier circuit.

In addition, a reference voltage V_{REF} used by an error amplifier AMP1 is supplied to a replica next-stage circuit (denoted by "replica CKT_NXT") 516. Hence, the reference voltage V_{REF} is received at an input node of the replica next-stage circuit 516, an internal-node voltage V_{REF_INT1} is generated at an internal node of the replica next-stage circuit 516, and an output voltage V_{REF_OUT2} is generated at an output node of the replica next-stage circuit 516. It should be noted that a voltage-to-voltage (V-V) characteristic between V_{OUT} and V_{OUT2} is the same as that between V_{REF} and V_{REF_OUT2}, and the V-V characteristic between V_{OUT} and V_{INT1} is the same as that between V_{REF} and V_{REF_INT1}.

In this embodiment, the bias current and the output mean voltage are programmed independently. Regarding the biasing circuit 506, it includes an error amplifier AMP2, a low-pass filter 514, the replica next-stage circuit 516, and a capacitor C2. The replica next-stage circuit 516 corresponds to the next-stage circuit 10. Specifically, the replica next-stage circuit 516 is a replica of the next-stage circuit 10, where the V-V characteristic of the replica next-stage circuit 516 may be the same as that of the next-stage circuit 10. The error amplifier AMP2 has a first input terminal, a second input terminal, and an output terminal, where the first input terminal is configured to receive an input voltage V_{DC2} indicative of a mean voltage, the second input terminal is configured to receive a reference voltage V_{REF2}, and the bias voltage V_{CM_N} is generated at the output terminal. The major difference between the biasing circuits 306 and 506 is that the reference voltage V_{REF2} is provided from the replica next-stage circuit 516.

In a first exemplary design of the biasing circuit 506, the reference voltage V_{REF2} is set by the output voltage V_{REF_OUT2} generated at the output node of the replica next-stage circuit 516; and the low-pass filter 514 is coupled between the first input terminal of the error amplifier AMP2 and the output node of the next-stage circuit 10, and is configured to apply low-pass filtering to the output voltage V_{OUT2} for generating the input voltage V_{DC2}. Specifically, the input voltage V_{DC2} is indicative of an output mean voltage of the next-stage circuit 10 due to the low-pass filter output being a DC component of the output voltage V_{OUT2}.

In a second exemplary design of the biasing circuit 506, the reference voltage V_{REF2} is set by the internal-node voltage V_{REF_INT1} generated at the internal node of the replica next-stage circuit 516; and the low-pass filter 514 is coupled between the first input terminal of the error amplifier AMP2 and the internal node of the next-stage circuit 10, and is configured to apply low-pass filtering to the internal-node voltage V_{INT1} for generating the input voltage V_{DC2}. Specifically, the input voltage V_{DC2} is indicative of an internal mean voltage of the next-stage circuit 10 due to the low-pass filter output being a DC component of the internal-node voltage V_{INT1}.

The error amplifier AMP2 adaptively adjusts the bias voltage V_{CM_N} according to an error between the reference voltage V_{REF2} and the input voltage V_{DC2}. The bias voltage V_{CM_N} is held by the capacitor C2. Since the drain terminal of the transistor MN2 is coupled to a fixed voltage (i.e., supply voltage VDD), the input voltage V_{DC2} (e.g., mean voltage of V_{OUT2} or V_{INT1}) changes in response to a change of the bias voltage (i.e., gate voltage of transistor MN2) V_{CM_N}. In other words, the error amplifier AMP2 adaptively adjusts the bias voltage V_{CM_N} to minimize the error between the reference voltage V_{REF2} and the input voltage V_{DC2}. Hence, the error amplifier AMP2 will make the input voltage V_{DC2} (e.g., mean voltage of V_{OUT2} or V_{INT1}) same as or close to the reference voltage V_{REF2} (e.g., V_{REF_OUT2} or V_{REF_}INTI). Since the next-stage circuit 10 and the replica next-stage circuit 516 have the same V-V characteristic, the mean of the output voltage V_{OUT} is the same as or close to the reference voltage V_{REF} when the input voltage V_{DC2} (e.g., mean voltage of V_{OUT2} or V_{INT1}) is the same as or close to the reference voltage V_{REF2} (e.g., V_{REF_OUT2} or V_{REF_INT1}). In other words, the bias voltage V_{CM_N} is adaptively adjusted to make the output mean voltage of the push-pull source follower circuit 500 equal to the reference voltage V_{REF}. In this embodiment, the reference voltage V_{REF} is programmable, and the output mean voltage of the push-pull source follower circuit 500 is set by programming the reference voltage V_{REF} provided by a voltage generator (not shown). To put it simply, the reference voltage V_{REF} is one programmable parameter of the push-pull source follower circuit 500.

Regarding the biasing circuit 504, it includes a replica source follower 511, a current source 512, the error amplifier AMP1, and a capacitor C1. The replica source follower 511 corresponds to the transistor MP2 of the main source follower 502, and includes a transistor MP1, where the transistor MP1 is a PMOS transistor acting as a P-type source follower. The transistor MP1 has a gate terminal (which acts as a control terminal), a source terminal (which acts as a first connection terminal), and a drain terminal (which acts as a second connection terminal), where the bias voltage V_{CM_P} is generated at the gate terminal, and the drain terminal is coupled to the power rail on which the ground voltage GND is delivered. Specifically, the replica source follower 511 is a replica of the P-type source follower (i.e., transistor MP2) included in the main source follower 502, where an I-V characteristic of the replica source follower 511 may be the same as that of the P-type source follower included in the main source follower 502. In some embodiments of the present invention, the replica source follower 511 (particularly, transistor MP1 of replica source follower 511) may be a scaled version of the P-type source follower in the main source follower 502 (particularly, transistor MP2 of main source follower 502). For example, the transistor MP1 may be a scaled-down version of the transistor MP2 for power saving and area saving. However, this is for illustrative purposes only, and is not meant to be a limitation of the present invention.

The error amplifier AMP1 has a first input terminal, a second input terminal, and an output terminal, where the first input terminal is coupled to the source terminal of the transistor MP1, the second input terminal is configured to receive the reference voltage V_{REF} (which is a target level of the output mean voltage), and the output terminal is coupled to the gate terminal of the transistor MP1.

The current source 512 is coupled between the first input terminal of the error amplifier AMP1 and the power rail on which the supply voltage VDD is delivered, and is configured to provide a reference current I_{bias}. The reference current I_{bias} acts as a bias current flowing through the transistor MP1, such that an output voltage V_{REP_O} of the replica source follower 511 is established at the source terminal of the transistor MP1 under a condition that the bias voltage V_{CM_P} is applied to the gate terminal of the transistor MP1. The error amplifier AMP1 adaptively adjusts the bias voltage V_{CM_P} according to an error between the output voltage V_{REP_O} and the reference voltage V_{REF}. The bias voltage V_{CM_P} is held by the capacitor C1. Since the reference current I_{bias} flowing through the transistor MP1 has a constant current value, the output voltage (i.e., source voltage of transistor MP1) V_{REP_O} changes in response to a change of the bias voltage (i.e., gate voltage of transistor MP1) V_{CM_P}. In other words, the error amplifier AMP1 adaptively adjusts the bias voltage V_{CM_P} to minimize the error between the output voltage V_{REP_O} and the reference voltage V_{REF}. Hence, the error amplifier AMP1 will make the output voltage V_{REP_O} same as or close to the reference voltage V_{REF}.

Since the replica source follower 511 is a replica (e.g., scaled version) of the P-type source follower of the main source follower 502, a bias current of the main source follower 502 is also a replica (e.g., scaled version) of the reference current I_{bias} under a condition that gate terminals of transistors MP1 and MP2 are biased by the same bias voltage V_{CM_P}, drain terminals of transistors MP1 and MP2 are set by the same ground voltage GND, and source terminals of transistors MP1 and MP2 have the same DC voltage V_{REP_O} = V_{REF} = mean of V_{OUT}. In this embodiment, the reference current I_{bias} is programmable, and the bias current of the main source follower 502 is set by programming the reference current I_{bias} provided by the current source 512. To put it simply, the reference current I_{bias} is another programmable parameter of the push-pull source follower circuit 500.

Regarding the push-pull source follower circuit 500, the biasing circuit 504 is used to set the bias voltage V_{CM_P} of the P-type source follower of the main source follower 502, and the biasing circuit 506 is used to set the bias voltage V_{CM_N} of the N-type source follower of the main source follower 502. However, this is for illustrative purposes only, and is not meant to be a limitation of the present invention. Alternatively, roles of the biasing circuits 504 and 506 may be swapped.

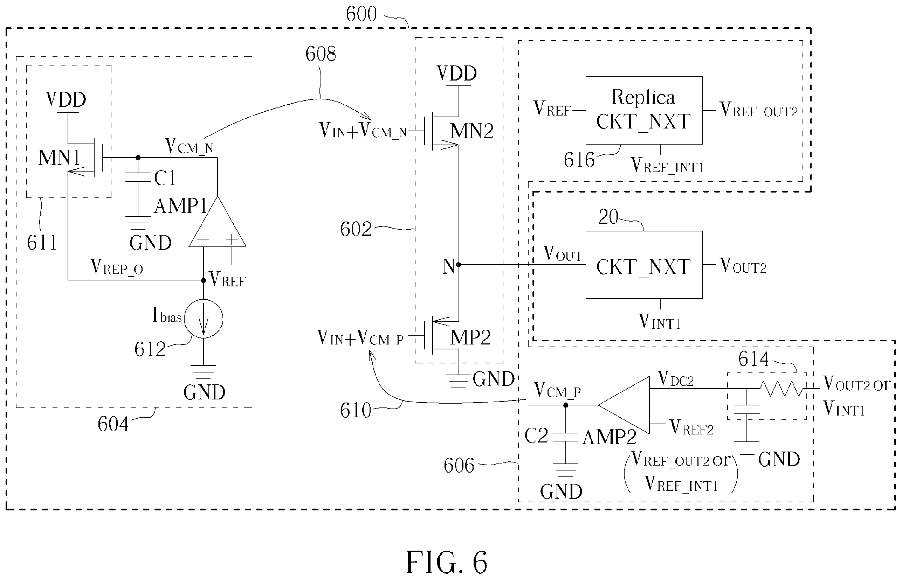

FIG. 6 is a diagram illustrating a sixth push-pull source follower design using the proposed biasing technique according to an embodiment of the present invention. The push-pull source follower circuit 600 is based on a complementary structure, and adopts the proposed biasing technique to independently program a bias current and an output mean voltage. In this embodiment, the push-pull source follower circuit 600 includes a main source follower 602 and a plurality of biasing circuits 604 and 606. The main source follower 602 includes transistors MN2 and MP2, where the transistor MN2 is an NMOS transistor acting as an N-type source follower, and the transistor MP2 is a PMOS transistor acting as a P-type source follower. The transistor MN2 has a gate terminal (which acts as a control terminal), a source terminal (which acts as a first connection terminal), and a drain terminal (which acts as a second connection terminal), where the source terminal is coupled to an output node N of the push-pull source follower circuit 600, and the drain terminal is coupled to a power rail on which a supply voltage VDD is delivered. The transistor MP2 has a gate terminal (which acts as a control terminal), a source terminal (which acts as a first connection terminal, and a drain terminal (which acts as a second connection terminal), where the source terminal is coupled to the output node N of the push-pull source follower circuit 600, and the drain terminal is coupled to a power rail on which a ground voltage GND is delivered.

The biasing circuit 604 is configured to program a bias current of the main source follower 602 through generating and outputting a bias voltage V_{CM_N} to the gate terminal of the transistor MN2. The bias voltage V_{CM_N} may be supplied to the gate terminal of the transistor MN2 through a coupling circuit 608 such as an active coupler or a passive coupler. For example, the coupling circuit 608 may be implemented using a DC level shifter including an AC coupling capacitor and a DC bias resistor, where the AC coupling capacitor passes an AC component of an input voltage V_{IN}, and the DC bias resistor adds a DC bias (i.e., bias voltage V_{CM_N}) to the AC component V_{IN}, thus resulting in a gate voltage (V_{IN}+V_{CM_N}) at the gate terminal of the transistor MN2.

The biasing circuit 606 is configured to program an output mean voltage (i.e., a DC level of an output voltage V_{OUT}) of the push-pull source follower circuit 600 through generating and outputting a bias voltage V_{CM_P} to the gate terminal of the transistor MP2. The bias voltage V_{CM_P} may be supplied to the gate terminal of the transistor MP2 through a coupling circuit 610 such as an active coupler or a passive coupler. For example, the coupling circuit 610 may be implemented using a DC level shifter including an AC coupling capacitor and a DC bias resistor, where the AC coupling capacitor passes an AC component of the input voltage V_{IN}, and the DC bias resistor adds a DC bias (i.e., bias voltage V_{CM_P}) to the AC component V_{IN}, thus resulting in a gate voltage (V_{IN}+V_{CM_P}) at the gate terminal of the transistor MP2.

As shown in FIG. 6, the output voltage V_{OUT} of the push-pull source follower circuit 600 is supplied to a next-stage circuit (denoted by "CKT_NXT") 20. Hence, the output voltage V_{OUT} of the push-pull source follower circuit 600 is received at an input node of the next-stage circuit 20, an internal-node voltage V_{INT1} is generated at an internal node of the next-stage circuit 20, and an output voltage V_{OUT2} is generated at an output node of the next-stage circuit 20. It should be noted that the next-stage circuit 20 may be any arbitrary circuit depending upon actual design considerations. For example, the next-stage circuit 20 may be an RLC network, a buffer circuit, or an amplifier circuit.

In addition, a reference voltage V_{REF} used by an error amplifier AMP1 is supplied to a replica next-stage circuit (denoted by "replica CKT_NXT") 616. Hence, the reference voltage V_{REF} is received at an input node of the replica next-stage circuit 616, an internal-node voltage V_{REF_INT1} is generated at an internal node of the replica next-stage circuit 616, and an output voltage V_{REF_OUT2} is generated at an output node of the replica next-stage circuit 616. It should be noted that the V-V characteristic between V_{OUT} and V_{OUT2} is the same as that between V_{REF} and V_{REF_OUT2}, and the V-V characteristic between V_{OUT} and V_{INT1} is the same as that between V_{REF} and V_{REF_INT1}.

In this embodiment, the bias current and the output mean voltage are programmed independently. Regarding the biasing circuit 606, it includes an error amplifier AMP2, a low-pass filter 614, the replica next-stage circuit 616, and a capacitor C2. The replica next-stage circuit 616 corresponds to the next-stage circuit 20. Specifically, the replica next-stage circuit 616 is a replica of the next-stage circuit 20, where the V-V characteristic of the replica next-stage circuit 616 may be the same as that of the next-stage circuit 20. The error amplifier AMP2 has a first input terminal, a second input terminal, and an output terminal, where the first input terminal is configured to receive an input voltage V_{DC2} indicative of a mean voltage, the second input terminal is configured to receive a reference voltage V_{REF2}, and the bias voltage V_{CM_P} is generated at the output terminal. The major difference between the biasing circuits 406 and 606 is that the reference voltage V_{REF2} is provided from the replica next-stage circuit 616.

In a first exemplary design of the biasing circuit 606, the reference voltage V_{REF2} is set by the output voltage V_{REF_OUT2} generated at the output node of the replica next-stage circuit 616; and the low-pass filter 614 is coupled between the first input terminal of the error amplifier AMP2 and the output node of the next-stage circuit 20, and is configured to apply low-pass filtering to the output voltage V_{OUT2} for generating the input voltage V_{DC2}. Specifically, the input voltage V_{DC2} is indicative of an output mean voltage of the next-stage circuit 20 due to the low-pass filter output being a DC component of the output voltage V_{OUT2}.

In a second exemplary design of the biasing circuit 606, the reference voltage V_{REF2} is set by the internal-node voltage V_{REF_INT1} generated at the internal node of the replica next-stage circuit 616; and the low-pass filter 614 is coupled between the first input terminal of the error amplifier AMP2 and the internal node of the next-stage circuit 20, and is configured to apply low-pass filtering to the internal-node voltage V_{INT1} for generating the input voltage V_{DC2}. Specifically, the input voltage V_{DC2} is indicative of an internal mean voltage of the next-stage circuit 20 due to the low-pass filter output being a DC component of the internal-node voltage V_{INT1}.

The error amplifier AMP2 adaptively adjusts the bias voltage V_{CM_P} according to an error between the reference voltage V_{REF2} and the input voltage V_{DC2}. The bias voltage V_{CM_P} is held by the capacitor C2. Since the drain terminal of the transistor MP2 is coupled to a fixed voltage (i.e., ground voltage GND), the input voltage V_{DC2} (e.g., mean voltage of V_{OUT2} or V_{INT1}) changes in response to a change of the bias voltage (i.e., gate voltage of transistor MP2) V_{CM_P}. In other words, the error amplifier AMP2 adaptively adjusts the bias voltage V_{CM_P} to minimize the error between the reference voltage V_{REF2} and the input voltage V_{DC2}. Hence, the error amplifier AMP2 will make the input voltage V_{DC2} (e.g., mean voltage of V_{OUT2} or V_{INT1}) same as or close to the reference voltage V_{REF2} (e.g., V_{REF_OUT2} or V_{REF_}INT1). Since the next-stage circuit 20 and the replica next-stage circuit 616 have the same V-V characteristic, the mean of the output voltage V_{OUT} is the same as or close to the reference voltage V_{REF} when the input voltage V_{DC2} (e.g., mean voltage of V_{OUT2} or V_{INT1}) is the same as or close to the reference voltage V_{REF2} (e.g., V_{REF_OUT2} or V_{REF_INT1}). In other words, the bias voltage V_{CM_P} is adaptively adjusted to make the output mean voltage of the push-pull source follower circuit 600 equal to the reference voltage V_{REF}. In this embodiment, the reference voltage V_{REF} is programmable, and the output mean voltage of the push-pull source follower circuit 600 is set by programming the reference voltage V_{REF} provided by a voltage generator (not shown). To put it simply, the reference voltage V_{REF} is one programmable parameter of the push-pull source follower circuit 600.

Regarding the biasing circuit 604, it includes a replica source follower 611, a current source 612, the error amplifier AMP1, and a capacitor C1. The replica source follower 611 corresponds to the transistor MN2 of the main source follower 602, and includes a transistor MN1, where the transistor MN1 is an NMOS transistor acting as an N-type source follower. The transistor MN1 has a gate terminal (which acts as a control terminal), a source terminal (which acts as a first connection terminal), and a drain terminal (which acts as a second connection terminal), where the bias voltage V_{CM_N} is generated at the gate terminal, and the drain terminal is coupled to the power rail on which the supply voltage VDD is delivered. Specifically, the replica source follower 611 is a replica of the N-type source follower (i.e., transistor MN2) included in the main source follower 602, where the I-V characteristic of the replica source follower 611 may be the same as that of the N-type source follower included in the main source follower 602. In some embodiments of the present invention, the replica source follower 611 (particularly, transistor MN1 of replica source follower 611) may be a scaled version of the N-type source follower in the main source follower 602 (particularly, transistor MN2 of main source follower 602). For example, the transistor MN1 may be a scaled-down version of the transistor MN2 for power saving and area saving. However, this is for illustrative purposes only, and is not meant to be a limitation of the present invention.

The error amplifier AMP1 has a first input terminal, a second input terminal, and an output terminal, where the first input terminal is coupled to the source terminal of the transistor MN1, the second input terminal is configured to receive the reference voltage V_{REF} (which is a target level of the output mean voltage), and the output terminal is coupled to the gate terminal of the transistor MN1.

The current source 612 is coupled between the first input terminal of the error amplifier AMP1 and the power rail on which the ground voltage GND is delivered, and is configured to provide a reference current I_{bias}. The reference current I_{bias} acts as a bias current flowing through the transistor MN1, such that an output voltage V_{REP_O} of the replica source follower 611 is established at the source terminal of the transistor MN1 under a condition that the bias voltage V_{CM_N} is applied to the gate terminal of the transistor MN1. The error amplifier AMP1 adaptively adjusts the bias voltage V_{CM_N} according to an error between the output voltage V_{REP_O} and the reference voltage V_{REF}. The bias voltage V_{CM_N} is held by the capacitor C1. Since the reference current I_{bias} flowing through the transistor MN1 has a constant current value, the output voltage (i.e., source voltage of transistor MN1) V_{REP_O} changes in response to a change of the bias voltage (i.e., gate voltage of transistor MN1) V_{CM_N}. In other words, the error amplifier AMP1 adaptively adjusts the bias voltage V_{CM_N} to minimize the error between the output voltage V_{REP_O} and the reference voltage V_{REF}. Hence, the error amplifier AMP1 will make the output voltage V_{REP_O} same as or close to the reference voltage V_{REF}.

Since the replica source follower 611 is a replica (e.g., scaled version) of the N-type source follower of the main source follower 602, a bias current of the main source follower 602 is also a replica (e.g., scaled version) of the reference current I_{bias} under a condition that gate terminals of transistors MN1 and MN2 are biased by the same bias voltage V_{CM_N}, drain terminals of transistors MN1 and MN2 are set by the same supply voltage VDD, and source terminals of transistors MN1 and MN2 have the same DC voltage V_{REP_O} = V_{REF} = mean of V_{OUT}. In this embodiment, the reference current I_{bias} is programmable, and the bias current of the main source follower 602 is set by programming the reference current I_{bias} provided by the current source 612. To put it simply, the reference current I_{bias} is another programmable parameter of the push-pull source follower circuit 600.

## Claims

1. A push-pull source follower circuit (100, 200, 300, 400, 500, 600) **characterized by**:
a main source follower (102, 202, 302, 402, 502, 602), comprising:
a first transistor (MP2, MN2), having a control terminal, a first connection terminal, and a second connection terminal, wherein the second connection terminal of the first transistor (MP2, MN2) is coupled to a first power rail (GND, VDD), and the first terminal of the first transistor (MP2, MN2) is coupled to an output node (N) of the push-pull source follower circuit (100, 200, 300, 400, 500, 600); and
a second transistor (MN2, MP2), having a control terminal, a first connection terminal, and a second connection terminal, wherein the second connection terminal of the second transistor (MN2, MP2) is coupled to a second power rail (VDD, GND), the first terminal of the second transistor (MN2, MP2) is coupled to the output node (N) of the push-pull source follower circuit (100, 200, 300, 400, 500, 600), and the first transistor and the second transistor comprise an N-type transistor (MN2) and a P-type transistor (MP2);
a first biasing circuit (104, 204, 304, 404, 504, 604), configured to program a bias current of the main source follower (102, 202, 302, 402, 502, 602) through generating and outputting a first bias voltage (V_{CM_P}, V_{CM_N}) to the control terminal of the first transistor (MP2, MN2); and
a second biasing circuit (106, 206, 306, 406, 506, 606), configured to program an output mean voltage of the push-pull source follower circuit (100, 200, 300, 400, 500, 600) through generating and outputting a second bias voltage (V_{CM_N}, V_{CM_P}) to the control terminal of the second transistor (M2, MP2);
wherein the bias current and the output mean voltage are programmed independently.

2. The push-pull source follower circuit (100, 200, 300, 400, 500, 600) of claim 1, **characterized in that** the first biasing circuit (104, 204, 304, 404, 504, 604) comprises:
a replica source follower (111, 211, 311, 411, 511, 611), wherein the replica source follower (111, 211, 311, 411, 511, 611) corresponds to the first transistor (MP2, MN2) of the main source follower (102, 202, 302, 402, 502, 602), and comprises:
a third transistor (MP1, MN1), having a control terminal, a first connection terminal, and a second connection terminal, wherein the first bias voltage (V_{CM_P}, V_{CM_N}) is generated at the control terminal of the third transistor (MP1, MN1), and the second connection terminal is coupled to the first power rail (GND, VDD);
a first error amplifier (AMP1), having a first input terminal, a second input terminal, and an output terminal, wherein the first input terminal of the first error amplifier (AMP1) is coupled to the first connection terminal of the third transistor (MP1, MN1), the second input terminal of the first error amplifier (AMP1) is configured to receive a first input voltage (V_{DC1}, V_{REF}) indicative of the output mean voltage, and the output terminal of the first error amplifier (AMP1) is coupled to the control terminal of the third transistor (MP1, MN1); and
a current source (112, 212, 312, 412, 512, 612), coupled to the first connection terminal of the third transistor (MP1, MN1), and configured to provide a reference current (I_{bias}).

3. The push-pull source follower circuit (100, 200, 300, 400, 500, 600) of claim 2, **characterized in that** the reference current (I_{bias}) is programmable, and the bias current of the main source follower (102, 202, 302, 402, 502, 602) is set by programming the reference current (I_{bias}).

4. The push-pull source follower circuit (100, 200) of claim 2, **characterized in that** the first biasing circuit (104, 204) further comprises:
a first low-pass filter (114, 214), coupled between the second input terminal of the first error amplifier (AMP1) and the output node (N) of the push-pull source follower circuit (100, 200), wherein the first low-pass filter (114, 214) is configured to apply low-pass filtering to an output voltage (V_{OUT}) of the push-pull source follower circuit (100, 200) for generating the first input voltage (V_{DC1}).

5. The push-pull source follower circuit of claim 4, **characterized in that** the second biasing circuit (106, 206) comprises:
a second error amplifier (AMP2), having a first input terminal, a second input terminal, and an output terminal, wherein the first input terminal of the second error amplifier (AMP2) is configured to receive a second input voltage (V_{DC2}) indicative of a mean voltage, and the second input terminal of the second error amplifier (AMP2) is configured to receive a reference voltage (V_{REF}), and the second bias voltage (V_{CM_N}, V_{CM_P}) is generated at the output terminal of the second error amplifier (AMP2).

6. The push-pull source follower circuit (100, 200) of claim 5, **characterized in that** the second biasing circuit (106, 206) further comprises:
a second low-pass filter (116, 216), coupled between the first input terminal of the second error amplifier (AMP2) and the output node of the push-pull source follower circuit (100, 200), wherein the second low-pass filter (116, 216) is configured to apply low-pass filtering to the output voltage (V_{OUT}) of the push-pull source follower circuit (100, 200) for generating the second input voltage (V_{DC2}); or
wherein the output voltage (V_{OUT}) of the push-pull source follower (100, 200) is supplied to a next-stage circuit (10, 20), and the second biasing circuit (106, 206) further comprises:
a second low-pass filter (116, 216), coupled between the first input terminal of the second error amplifier (AMP2) and an output node of the next-stage circuit (10, 20), wherein the second low-pass filter (116, 216) is configured to apply low-pass filtering to an output voltage (V_{OUT2}) of the next-stage circuit (10, 20) for generating the second input voltage (V_{DC2}); or
wherein the output voltage (V_{OUT}) of the push-pull source follower (100, 200) is supplied to a next-stage circuit (10, 20), and the second biasing circuit (106, 206) further comprises:
a second low-pass filter (116, 216), coupled between the first input terminal of the second error amplifier (AMP2) and an internal node of the next-stage circuit (10, 20), wherein the second low-pass filter (116, 216) is configured to apply low-pass filtering to an internal-node voltage (V_{INT1}) of the next-stage circuit (10, 20) for generating the second input voltage (V_{DC1}).

7. The push-pull source follower circuit (100, 200) of claim 5, **characterized in that** the reference voltage (V_{REF}) is programmable, and the output mean voltage of the push-pull source follower circuit (100, 200) is set by programming the reference voltage (V_{REF}).

8. The push-pull source follower circuit (300, 400, 500, 600) of claim 2, **characterized in that** the first input voltage is set by a first reference voltage (V_{REF}).

9. The push-pull source follower circuit (300, 400) of claim 8, **characterized in that** the second biasing circuit (306, 406) comprises:
a second error amplifier (AMP2), having a first input terminal, a second input terminal, and an output terminal, wherein the first input terminal of the second error amplifier (AMP2) is configured to receive a second input voltage (V_{DC2}) indicative of the output mean voltage, and the second input terminal is configured to receive the first reference voltage (V_{REF}), and the second bias voltage (V_{CM_N}, V_{CM_P}) is generated at the output terminal of the second error amplifier (AMP2).

10. The push-pull source follower circuit (300, 400) of claim 9, **characterized in that** the second biasing circuit (306, 406) further comprises:
a second low-pass filter (314, 414), coupled between the first input terminal of the second error amplifier (AMP2) and the output node (N) of the push-pull source follower circuit (300, 400), wherein the second low-pass filter (314, 414) is configured to apply low-pass filtering to the output voltage (V_{OUT}) of the push-pull source follower circuit (300, 400) for generating the second input voltage (V_{DC2}).

11. The push-pull source follower circuit (300, 400) of claim 9, **characterized in that** the first reference voltage (V_{REF}) is programmable, and the output mean voltage of the push-pull source follower circuit (300, 400) is set by programming the first reference voltage (V_{REF}).

12. The push-pull source follower circuit (500, 600) of claim 8, **characterized in that** the output voltage (V_{OUT}) of the push-pull source follower (500, 600) is supplied to a next-stage circuit (10, 20), and the second biasing circuit (506, 606) comprises:
a replica next-stage circuit (516, 616), wherein the replica next-stage circuit (516, 616) corresponds to the next-stage circuit (10, 20), and the first reference voltage (V_{REF}) is supplied to the replica next-stage circuit (516, 616); and
a second error amplifier (AMP2), having a first input terminal, a second input terminal, and an output terminal, wherein the first input terminal of the second error amplifier (AMP2) is configured to receive a second input voltage (V_{DC2}) indicative of a mean voltage, and the second input terminal of the second error amplifier (AMP2) is configured to receive a second reference voltage (V_{REF2}) obtained from the replica next-stage circuit (516, 616), and the second bias voltage (V_{CM_N}, V_{CM_P}) is generated at the output terminal of the second error amplifier (AMP2).

13. The push-pull source follower circuit (500, 600) of claim 12, **characterized in that** the second reference voltage (V_{REF2}) is generated at an output node of the replica next-stage circuit (516, 616), and the second biasing circuit (506, 606) further comprises:
a second low-pass filter (514, 614), coupled between the first input terminal of the second error amplifier (AMP2) and an output node of the next-stage circuit (10, 20), wherein the second low-pass filter (514, 614) is configured to apply low-pass filtering to an output voltage (V_{OUT2}) of the next-stage circuit (10, 20) for generating the second input voltage (V_{DC2}); or
wherein the second reference voltage (V_{REF2}) is generated at an internal node of the replica next-stage circuit (516, 616), and the second biasing circuit (506, 606) further comprises:
a second low-pass filter (514, 614), coupled between the first input terminal of the second error amplifier (AMP2) and an internal node of the next-stage circuit (10, 20), wherein the second low-pass filter (514, 614) is configured to apply low-pass filtering to an internal-node voltage (V_{INT1}) of the next-stage circuit (10, 20) for generating the second input voltage (V_{DC2}).

14. The push-pull source follower circuit (500, 600) of claim 12, **characterized in that** the second reference voltage (V_{REF2}) is programmable, and the output mean voltage of the push-pull source follower circuit (500, 600) is set by programming the second reference voltage (V_{REF2}).

15. The push-pull source follower circuit (100, 200, 300, 400, 500, 600) of claim 2, **characterized in that** the third transistor (MP1, MN1) of the replica source follower (111, 211, 311, 411, 511, 611) is a scaled version of the first transistor (MP2, MN2) of the main source follower (102, 202, 302, 402, 502, 602).
